# EUROPEAN PATENT SPECIFICATION

(11) **EP 1 111 086 B1**
(45) Date of publication and mention of the grant of the patent: **08.04.2009**
(21) Application number: 00310812.3
(22) Date of filing: 05.12.2000
(51) Int. Cl.: C23C 14/32, B22D 11/00

(54) **Use of a cathode for cathodic arc deposition**
Verwendung einer Kathode zur Vakuumbogenverdampfung
Utilisation d'une cathode pour dépôt sous vide avec décharge d'arc

(30) Priority: 20.12.1999 US 467567
(43) Date of publication of application: 27.06.2001
(73) Proprietor: United Technologies Corporation, Hartford, CT 06101 (US)
(72) Inventor: Beers, Russell A., Manchester, Connecticut 06040 (US)
(74) Representative: Leckey, David Herbert

(56) References cited:
- EP-A- 0 899 772
- DD-A- 293 145
- US-A- 4 681 787
- US-A- 4 690 875
- PATENT ABSTRACTS OF JAPAN vol. 017, no. 492 (C-1107), 7 September 1993 (1993-09-07) & JP 05 125523 A (DAIDO STEEL CO LTD), 21 May 1993 (1993-05-21)
- PATENT ABSTRACTS OF JAPAN vol. 015, no. 100 (C-0813), 11 March 1991 (1991-03-11) & JP 02 311394 A (DAIDO STEEL CO LTD), 26 December 1990 (1990-12-26)
- PATENT ABSTRACTS OF JAPAN vol. 011, no. 259 (C-441), 21 August 1987 (1987-08-21) & JP 62 060863 A (MITSUBISHI HEAVY IND LTD;OTHERS: 01), 17 March 1987 (1987-03-17)

## Description

This invention relates to the field of cathodic arc deposition of metallic coatings. This invention also relates to the field of the production of cathodes for use in cathodic arc deposition.

In the field of gas turbine engines, metallic coatings of the overlay type described for example in U.S. Patents 4,585,481 and RE 32,121 have been widely applied to superalloy substrates by processes which include electron beam physical vapor deposition and thermal spray techniques. These prior art coating processes have strengths and weaknesses. Electron beam processes are costly and thermal spray processes produce porous coatings of variable thickness. In addition electron beam techniques cannot reliably deposit alloys whose constituents have substantially different vapor pressures.

Overlay coatings of the so-called MCrA1Y type are widely used in gas turbine applications. MCrA1Y compositions have been widely investigated and are described in many patents. Table I describes broad and intermediate ranges for MCrA1Y compositions and the nominal preferred composition of a composition widely used by the applicant in aircraft gas turbine applications. Hereinafter the term MCrA1Y will be understood to mean the compositions described in Table I unless otherwise indicated.

**TABLE I**

| | MCrAlY Compositions (wt. %) | | |
|---|---|---|---|
| | Broad | Intermediate | Nominal Specific Preferred |
| M⁽¹⁾ | Bal | Bal | 22% Co, Bal Ni |
| Cr | 10-30 | 13-25 | 17 |
| Al | 6-20 | 10-14 | 12.5 |
| Y⁽²⁾ + Rare Earths | 0-2⁽³⁾ | 2-1.0⁽⁴⁾ | .6 |
| Hf | 0-5⁽⁵⁾ | 0-5⁽⁶⁾ | .25 |
| Si | 0-3 | 0-2 | .4 |
| Rh + Pt + Pd + Os | 0-15 | 0-10 | --- |
| Sc + La + Ce + Yb⁽²⁾ | 0-2 | 0-1.5 | --- |
| Ti+Zr - | 0-5 | 0-3 | --- |
| Nb + Re + W + Mn | 0-15 | 0-10 | --- |
| B | 0-2 | 0-1.0 | --- |
| C | 0-2 | 0-1.0 | --- |
| Ga | 0-10 | 0-5.0 | --- |

| | | | |
|---|---|---|---|
| (1) M can be Ni, Co, Fe and mixtures thereof; mixtures of Ni and Co are favored (2) Any rare earth material may be employed, but Y is preferred and at least .1% Y is more preferred (3) Y+Sc+La+Ce+Yb=1-1.2 (4) Y+Sc+La+Ce+Yb=.2-1.0 (5) Hf + Ti + Zr = 0-7 (6) Hf + Ti + Zr = 0-5 | | | |

Therefore, a need exists for a coating process which can predictably and repeatably produce thin, dense, uniform coatings, including alloy coatings whose constituents have substantially different vapor pressures. Coatings having intermetallic compositions have also been considered, for example coatings based on NiA1 are useful in some applications.

Unless otherwise noted, reference to metallic coatings and compositions will be understood to encompass pure metals, metallic alloys, intermetallic compositions, and combinations of the foregoing.

The cathodic arc process has previously been used to apply very thin coatings to substrates. Coatings of compounds such as titanium nitride and coatings of metallic materials such as chromium have been applied with typical thicknesses of less than about 25 microns (25 µm).

Titanium nitride coatings are used as hard wear resistant coatings on jewelry, cutting tools and drill bits and decorative coatings while chromium layers are used for decorative applications. Because such coatings provide the desired benefits in extremely thin layers there has been little reason to work on adapting the cathodic arc process to the economic application of substantially thicker coatings, i.e. 50-200 microns (50-200 µm).

Recently the applicant has undertaken an effort to modify and adapt the cathodic arc process to apply thicker coatings of complex metallic alloy coatings on to superalloy substrates, particularly on gas turbine airfoils. These thicknesses are required for long term durability. The apparatus which the applicant has developed is described in EP 899772, EP 905272, and EP 899773 to which further reference may be made as necessary. The apparatus shown and claimed in these publications is adapted to enable high rate cathodic arc deposition of complex metallic alloys, and adapted to produce uniform fine grained defect free coatings on superalloy substrates.

Some of the coating compositions which are desired to be deposited contain elements of widely varying vapor pressures, high vapor pressure elements such as A1 and Cr, and low vapor pressure elements such as Hf and Ta.

Cathodic arc deposition is suited for complex alloys because the cathodic arc process uses an electric arc to melt and vaporize a small portion of a target of cathode material. The energy density of the arc is sufficient to melt and vaporize all the material in that small spot, regardless of vapor pressure of the constituents. Vaporization is nearly instantaneous. Other evaporation processes such as electron beam physical vapor deposition processes (EBPVD) melt large quantities of material relative to the amount being evaporated, and it is difficult to evaporate materials whose constituents have widely differing vapor pressures.

In the course of development by the applicant of the high rate cathodic arc deposition process problems have been encountered with cathodes and cathode fabrication.

Conventional casting is a seemingly reasonable process to produce cathodes, but cathodes produced by conventional casting techniques invariably contain porosity, on the order of a few percent or greater. The presence of even a small amount of porosity significantly and detrimentally affects the quality of subsequently applied coating. Pores in cast materials usually contain gases, and usually the pore surfaces are contaminated with carbides, oxides, nitrides and the like. During cathodic arc deposition, when the arc encounters a cavity, the contamination is vaporized and forms part of the coating, causing coating defects, or causing violent eruption at the surface of the cathode leading to large droplets being discharged, forming inhomogeneous protrusions in the coating being applied.

A related problem occurs when the surface of the casting is machined to remove surface oxides and contamination prior to cathode use. Where porosity is exposed during machining, the machining coolant will penetrate the cavity and coat the cavity surfaces. During subsequent cathodic arc deposition this residual coolant material will contaminate the atmosphere in the coater, significantly reducing coating quality.

In addition, conventional casting processes usually expose the molten metal to ceramic surfaces such as crucibles and tundishes. Conventionally cast materials often contain ceramic inclusions. During the deposition process the ceramic inclusions not only interfere with the path of the arc, but are themselves evaporated and redeposited as part of the coating, producing an undesirable result. Even a relatively small ceramic inclusion, when vaporized, will form a very thin large area layer on the substrate being coated, and this layer causes coating spallation and similar adverse effects during service.

These problems led to the discovery that porosity free, ceramic free, high density cathodes are required. We believe that cathode densities in excess of 99% and preferably in excess of 99.3% of theoretical, and containing less than 10 ppm, preferably less than 5 ppm total oxygen, and less than 10 ppm, preferably less than 5 ppm of insoluble oxides are required.

Accordingly it is an object of the present invention to describe a cathode which is suited for the high rate deposition of high quality metallic coatings onto superalloy substrates using the cathodic arc deposition process.

It is another object to describe a cathode which is particularly suited for the high rate deposition of metallic coatings using the cathodic arc deposition process.

It is further object of the invention to describe a cathode which can be used in a cathodic arc coating process to deposit MCrA1Y-type protective coatings onto superalloy gas turbine components.

Finally, it is an object to describe methods of producing cathodes which can be used to apply coatings to metallic substrates at high rates without incurring the problems encountered using cathodes fabricated by conventional casting methods.

U.S. Patents RE32,121; 4,054,723; and 3,928,026 describe various overlay compositions of the MCrA1Y type. U.S. Patents 3,343,828; 4,641,704; and 4,690,875 describe various the electron beam melting, refining and casting processes. Reference may be made to these patents for further detail of compositions and techniques which may be employed in the performance of the present invention.

There is also disclosed herein a process for producing cathodic arc cathodes, which are effectively free from porosity and inclusions. More particularly there is disclosed a method of producing a metallic cathode material for use in the cathodic arc deposition of coatings including the steps of: a. melting and refining a metallic material in a vacuum. b. pouring said melted material into a cooled mold. c. withdrawing solidified material from said mold on a continuous or semi continuous basis. Also disclosed are the resultant, dense, pore free, inclusion free cathodes.

Also disclosed is a particular cathode geometry which is particularly suited for use in high rate cathodic arc deposition. According to the invention there is provided the use of as claimed in claim 1. There is also disclosed herein a cathode, which has been used in a cathodic arc coating apparatus, having a roughly hourglass geometry wherein the height of the hourglass is less than diameter of the hourglass at the ends of said hourglass.

There is also disclosed herein a cathode for use in a cathodic arc coating apparatus, having a thin adherent coating on its cylindrical surface, said coating having a composition, which differs from the composition of the bulk cathode.

In the preferred embodiment, cathode precursor material is produced by electron beam cold hearth refining (EBCHR), as generally described in U.S. Patents 3,343,828, 4,641,704 and 4,690,875 to which reference may be made for details of this process. The process described in these prior patents has previously been used to produce metallic stock for subsequent forging.

A starting alloy is melted in a vacuum using an electron beam and flows onto a water cooled copper hearth. A thin layer (skull) of cathode alloy solidifies on the hearth and remains in contact with the hearth and prevents contamination from the hearth material. The material flows from the skulled hearth into a cylindrical mold and solidifies, and is withdrawn on a continuous or semi continuous basis from the mold. The continuous solidification process permits entrapped gas to escape and provides molten metal to fill areas where shrinkage might otherwise occur.

The solidified ingot is cut into sections of appropriate thickness. The sections preferably then have one or more locating features to permit the cathode to be accurately aligned in the cathodic arc deposition apparatus. Surface treatments may be employed to remove surface contaminations prior to starting cathodic arc deposition.

A preferred embodiment of the invention will now be described with reference to the accompanying drawings in which:
FIG. 1 is a schematic diagram of the major elements of a cathodic arc apparatus.
FIG. 2 is a schematic drawing of the electron beam cold hearth refined casting apparatus.
FIG. 3 shows the geometry of the product produced by the apparatus shown in FIG. 2.
FIG. 4 shows the geometry of cathode for use in apparatus of the type shown in FIG. 1.
FIG. 5 shows the cathode geometry after it has been used for coating.
FIG. 6 shows a cathode having a surface coating.
As previously indicated there is a need for high density cathodes, free from contamination, for use in high rate cathodic arc deposition.

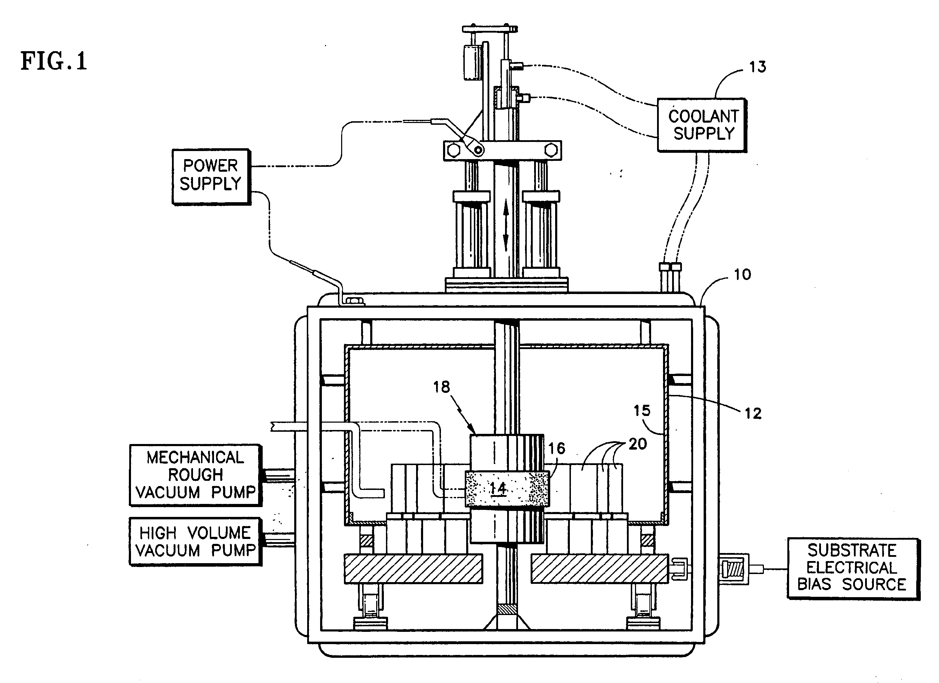

FIG. 1 is a schematic drawing of a cathodic arc apparatus; the apparatus is fully described in aforementioned EP 899772, EP 899773 and EP 905272, to which further reference may be made. Very briefly, the cathodic arc process occurs within inner chamber 12, which is surrounded by an outer vacuum chamber 10. Vacuum chamber 10 is provided with fluid cooling means 13. The vacuum chamber 10 has provisions for evacuation to provide a relatively high vacuum environment. The cathode 14 is located relatively centrally in the inner chamber 12. Various power supplies appropriately connected cause arcing to occur between the inner chamber walls 15 and the cylindrical surface 16 of the cathode 14. Assembly 18 preferably contains an assembly of magnets (not shown), which can be manipulated to influence the arc position and motion. Assembly 18 also provides conductive cooling to cathode 14. The parts 20 to be coated are located around the cathode 14 with provisions (not shown) to rotate and otherwise manipulate the parts to be coated so as to promote the formation of the uniform coating on the desired surfaces, in some circumstances the manipulation may be employed to put a coating of controlled, but varying, thickness on a part..

The present invention relates primarily to the fabrication of the cathode.

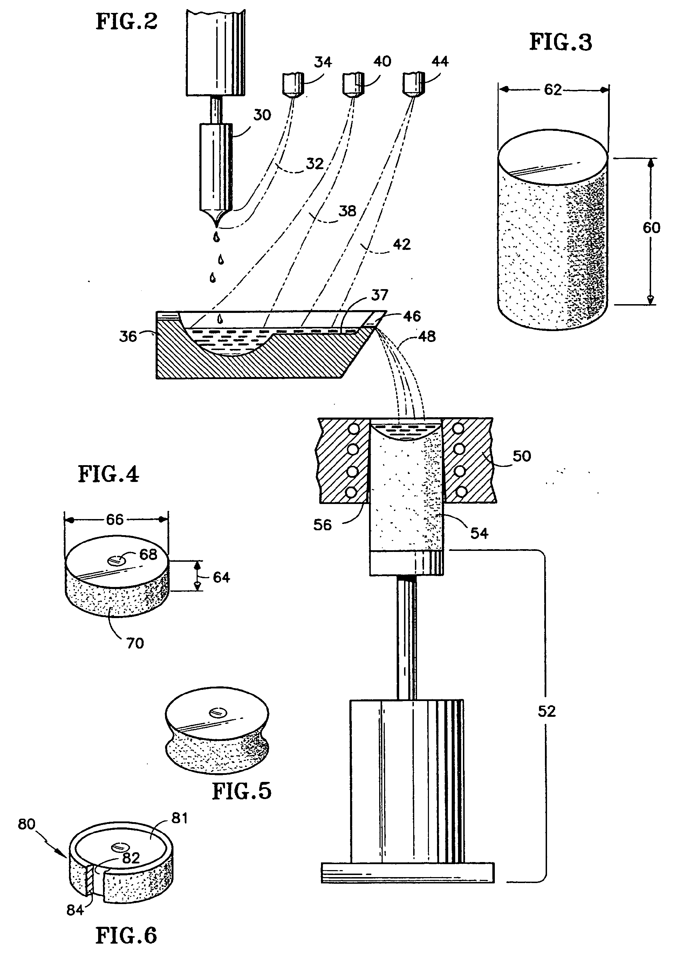

FIG. 2 shows the electron beam cold hearth refining technique. FIG. 2 is based on drawings found in U.S. Patent 4,190,404 to which further reference should be made for detail of the technique. Briefly, FIG. 2 provides starting ingot 30 which may be the cylindrical configuration, which is melted by an electron beam 32 from electron gun 34, and drips into the cold hearth 36, which is typically made of copper and water cooled. A thin layer 37 of solidified material forms on the hearth 36, separating the molten metal from the hearth and preventing contamination of the molten metal by the hearth material. A second electron beam 38 from electron gun 40, is scanned over the surface of the melted material 48 to keep it in a liquid state, while a third electron beam 42 from electron gun 44 is scanned over the lip 46 of the hearth 36 to keep the material 48 which flows over the lip from solidifying. The melted material 48 flows into the water cooled hollow metal mold 50, usually made of copper or steel, which has a withdrawal mechanism 52 so that as material solidifies within the mold, the solidified portion 54 is withdrawn from the bottom 56 of the mold 50 in a controlled fashion which is coordinated with the addition of liquid metal. The result is cylindrical ingot, shown in FIG. 3, whose diameter is determined by the mold geometry, and whose length is primarily limited by the size of starting ingot 30 and the dimensions of the vacuum chamber (not shown) which surrounds the apparatus. This type of semi continuous casting essentially substantially eliminates porosity. In an alternate process, the hearth may be eliminated, and melted metal from the starting ingot 10 may drip directly into the mold 30.

The continuous casting process may be performed using the apparatus and methods shown in U.S. Patents 4,558,729; 4,583,580; and 4,838,340 to produce a product similar to that described in U.S. Patents 4,681,787 and 4,690,875.

The product will be characterized by being dense, and containing low amounts of inclusions and dissolved gases. Typically the density will exceed 99.3% of the theoretical cast density of the material, will contain less than 10 ppm dissolved oxygen, preferably less than 5 ppm dissolved oxygen and will contain less than 10 ppm insoluble oxides and preferably less than 5 ppm of insoluble oxides.

The as cast product from which the invention cathodes are produced is shown in Fig. 3. The casting shown in Fig. 3 has an aspect ratio (length 60/diameter 62) substantially in excess of about 1, usually in excess of about 5.

The cast product of Fig. 3 is sliced into shorter right cylinders prior to producing the basic cathode of the present invention. Fig. 4 shows a slice of the casting of Fig. 3. The casting portion of Fig. 4 has an aspect ratio (length 64/diameter 66) of less than about 1, usually less than about .5. Preferably the cathode preform of Fig. 4 has one or more recesses 68 machined into one or both of its flat surfaces. These cooperate with corresponding mirror image locating features in the cathodic arc deposition apparatus and serve to accurately locate the cathode within the deposition apparatus and with respect to the components to be coated.

Prior to use as a cathode, the cathode preform of Fig. 4 is lightly machined on its cylindrical surface 70, for example by lathe turning or grinding, to remove surface contaminations, although other appropriate surface cleaning processes, such as grit blasting and/or chemical etching may also be employed. Aqueous and/or organic washes may be used as a final cleaning step.

The cathode dimensions are preferably correlated with the dimensions of the parts to be coated. The cathode thickness is usually from .3-3.0 times the dimension of the parts to be coated, measuring in the axial dimension of the cathode, and preferably from .5 to 2.0 times the part dimension when measured along an axis essentially parallel to the axis of the cylindrical cathode. For example, in coating a gas turbine airfoil having a 5 cm airfoil portion that requires coating, a cathode thickness of 1.5-15 cm, and preferably 2.5-10 cm may be employed.

The cathode preferably has a circular geometry, but a multi faceted quasi-cylindrical geometry having 6 or more sides is within the scope of the invention.

In use, the arc will traverse the cathode cylindrical surface under the influence of electrical and magnets tones, evaporating material which will be deposited on the parts being coated. Over time, the erosion will transform the original cylindrical cathode into an hourglass shape shown in Fig. 5.

The cathode composition will be similar to the composition desired in the coating. It has been observed that the chemistry of an alloy coating produced by cathodic arc deposition from a cathode will be generally similar to the cathode chemistry except for aluminum, which is often deposited at a lower level than is found in the starting cathode composition. Aluminum is a relatively light atom, and it is believed that after an aluminum atom is deposited on a substrate, that it may be knocked off by a subsequent impact of a heavy atom such as nickel, cobalt, tungsten etc.

Consequently, the cathodic chemistry is preferably adjusted by increasing the cathode aluminum level by up to 30% over the aluminum level desired in the coating. Thus for example, if a coating containing 10% Al was desired, a cathode containing up to about 13% Al might be employed; the amount of A1 added is largely a function of operating parameters, but is easily determined by one skilled in the art.

Fig. 6 shows an embodiment of the present invention comprising a cathode adapted to apply a coating of varying composition, which may be alternatively described as a multilayer coating. Cathode 80 has a central portion 81 made according to the present invention, by electron beam cold hearth refined semi-continuous casting. To the outer cylindrical surface 82 of cathode 80, there has been applied a layer 84 of material which will normally be of a different composition. During the cathodic arc deposition process, the initial layer applied to the parts being coated will have a composition which essentially corresponds to the composition of the layer 84 (taking the previously described resputtering of A1 into account).

Layer 84 may be applied by any of several well-known processes including thermal spray processes; plasma spray, flame spray, and HVOF; and other processes including electroplating. Of the thermal spray processes, LPPS (low pressure plasma spray) is preferred in order to minimize oxide formation in the coating. The thickness of layer 84 will typically range from about .5 mm to 5 mm and will be adjusted to obtain the desired thickness of intermediate coating composition. The composition of layer 84 may include elements such as Re to provide a diffusion barrier to reduce interdiffusion between the part substrate and the outer coating composition.

Although the invention has been shown and described with respect to detailed embodiments thereof, it should be understood by those skilled in the art that various changes in form and detail thereof may be made without departing from the scope of the claimed invention.

## Claims

1. The use of a cathode (14) in a cathodic arc coating apparatus, said cathode:
a. having a cylindrical geometry and an aspect ratio of less than 1;
b. having a density in excess of 99.3% of its theoretical maximum density; and
c. containing less than 10 ppm dissolved oxygen and 10 ppm insoluble oxides.

2. The use of a cathode as claimed in claim 1, said cathode having an MCrAlY composition.

3. The use of a cathode as claimed in claim 1 or 2, said cathode containing more aluminum than the amount of aluminum desired in the final coating produced from said cathode.

4. The use of a cathode as claimed in any preceding claim, said cathode having one or more locating features (68) which are adapted to interact with locating features in a cathodic apparatus, and which serve to locate said cathode in said apparatus.

5. The use of a cathode as claimed in any preceding claim, said cathode having a coating, said coating having a composition different from that of the bulk cathode.

6. The use of a cathode as claimed in any of claims 1 to 4, said cathode having a relatively thin adherent coating (84) on its cylindrical surface (82), said coating (84) having a composition, which differs from the composition of the bulk cathode.

7. The use of a cathode as claimed in any of claims 1 to 4, said cathode having an adherent coating (84) on its cylindrical surface (82), said coating (84) having a composition, which differs from the composition of the bulk cathode, said layer being between .5 and 5 mm thick.

## Patentansprüche

1. Verwendung einer Kathode (14) in einer kathodischen Bogen-Beschichtungsvorrichtung, wobei die Kathode:
a. eine zylindrische Geometrie und ein Höhe-Breite-Verhältnis von weniger als 1 hat;
b. eine Dichte von über 99,3% ihrer theoretischen maximalen Dichte hat; und
c. weniger als 10 ppm gelösten Sauerstoff und 10 ppm unlösliche Oxide enthält.

2. Verwendung einer Kathode wie in Anspruch 1 beansprucht, wobei die Kathode eine Zusammensetzung MCrAlY hat.

3. Verwendung einer Kathode wie in Anspruch 1 oder 2 beansprucht, wobei die Kathode mehr Aluminium enthält als die Menge an Aluminium, die in der endgültigen Beschichtung, die aus der Kathode hergestellt wird, gewünscht ist.

4. Verwendung einer Kathode wie in irgendeinem vorangehenden Anspruch beansprucht, wobei die Kathode ein oder mehrere Anbringungsmerkmale (68) hat, die dazu ausgelegt sind, mit Anbringungsmerkmalen in einer kathodischen Vorrichtung in Wechselwirkung zu treten, und die dazu dienen, die Kathode in der Vorrichtung anzubringen.

5. Verwendung einer Kathode wie in irgendeinem vorangehenden Anspruch beansprucht, wobei die Kathode eine Beschichtung hat, wobei die Beschichtung eine Zusammensetzung, die von derjenigen der Kathoden-Hauptmasse verschieden ist, hat.

6. Verwendung einer Kathode wie in einem der Ansprüche 1 bis 4 beansprucht, wobei die Kathode eine relativ dünne anhaftende Beschichtung (84) auf ihrer zylindrischen Oberfläche (82) hat, wobei die Beschichtung (84) eine Zusammensetzung, die sich von der Zusammensetzung der Kathoden-Hauptmasse unterscheidet, hat.

7. Verwendung einer Kathode wie in einem der Ansprüche 1 bis 4 beansprucht, wobei die Kathode eine anhaftende Beschichtung (84) auf ihrer zylindrischen Oberfläche (82) hat, wobei die Beschichtung (84) eine Zusammensetzung, die sich von der Zusammensetzung der Kathoden-Hauptmasse unterscheidet, hat, wobei die Schicht zwischen 0,5 und 5 mm dick ist.

## Revendications

1. Utilisation d'une cathode (14) dans un appareil de dépôt sous vide avec décharge d'arc, ladite cathode :
a. ayant une géométrie cylindrique et un rapport épaisseur/diamètre inférieur à 1 ;
b. ayant une densité supérieure à 99,3% de sa densité théorique maximum ; et
c. contenant moins de 10 ppm d'oxygène dissous et 10 ppm d'oxydes insolubles.

2. Utilisation d'une cathode selon la revendication 1, ladite cathode se composant de MCrAlY.

3. Utilisation d'une cathode selon la revendication 1 ou 2, ladite cathode contenant plus d'aluminium que la quantité d'aluminium souhaitée dans le revêtement final produit à partir de ladite cathode.

4. Utilisation d'une cathode selon l'une quelconque des revendications précédentes, ladite cathode ayant un ou plusieurs éléments de positionnement (68) qui sont prévus pour coopérer avec des éléments de positionnement dans un appareil cathodique, et qui servent à positionner ladite cathode dans ledit appareil.

5. Utilisation d'une cathode selon l'une quelconque des revendications précédentes, ladite cathode ayant un revêtement, ledit revêtement ayant une composition différente de celle du corps de la cathode.

6. Utilisation d'une cathode selon l'une quelconque des revendications 1 à 4, ladite cathode ayant un revêtement adhérent relativement mince (84) sur sa surface cylindrique (82), ledit revêtement (84) ayant une composition qui est différente de la composition du corps de la cathode.

7. Utilisation d'une cathode selon l'une quelconque des revendications 1 à 4, ladite cathode ayant un revêtement adhérent (84) sur sa surface cylindrique (82), ledit revêtement (84) ayant une composition qui est différente de la composition du corps de la cathode, ladite couche ayant une épaisseur comprise entre 0,5 et 5 mm.
